# EUROPEAN PATENT APPLICATION

(11) **EP 4 818 740 A1**
(43) Date of publication of application: **07.10.2026**
(21) Application number: 26168865.9
(22) Date of filing: 30.03.2026
(51) Int. Cl.: G01S 7/02, G01S 13/86, G01S 13/91

(54) **FIXING BRACKET FOR RADAR DEVICE AND RADAR ASSEMBLY**

(30) Priority: 01.04.2025 KR 20250042221
(71) Applicant: bitsensing Inc, Seongnam-si, Gyeonggi-do 13105 (KR)
(72) Inventor: KIM, Dong Hui, 14067 Anyang-si, Gyeonggi-do (KR); LEE, Dae Han, 21024 Incheon (KR); CHO, In Ho, 12780 Gwangju-si, Gyeonggi-do (KR)
(74) Representative: BCKIP Part mbB

(57) **Abstract**

A fixing bracket for a radar device includes a first part configured to define a first seating space to receive the radar device therein, and including a support extending from a rear side toward a front side to support the radar device from a lower side or a lateral side when the radar device is seated in the first seating space; a second part configured to define a second seating space to receive a junction box therein, being disposed on a rear side of the first part, and being integrally formed with the first part; and a coupling part configured to be integrally formed with the first part or the second part on a lower side of the second part and a rear side of the first part, extending in a longitudinal direction, and including a rear end portion bent upward to extend therefrom.

## Description

### TECHNICAL FIELD

The present disclosure relates to a fixing bracket for a radar device, and a radar assembly.

### BACKGROUND

Radar devices are utilized as primary sensing apparatuses across various application fields, such as traffic management, security surveillance, and industrial automation. In particular, a radar device may serve as a complex sensor configured to combine radar technology with image-based sensing technology, thereby enabling advanced traffic management functions, such as multi-lane object detection, traffic flow analysis, and incident detection. Such radar devices include a radar transceiver module configured to perform detection using electromagnetic waves as well as an ultra-high-definition (UHD) video camera and an artificial intelligence (Al) processor to analyze objects and events in real-time.

Since such radar devices include a plurality of electronic components, a significant amount of heat may be generated during high-output operations thereof. Specifically, in the event that heat generated from a graphics processing unit (GPU) used as the AI processor and from the radar transceiver module is not effectively dissipated, performance of the device may degrade, and long-term reliability thereof may be adversely affected. To address this issue, heat dissipation structures, such as thermal interface materials (TIM), Peltier elements, and heat sinks, may be employed. However, to effectively arrange such structures, a bracket design capable of stably fixing the entire device is essential.

Furthermore, since radar devices are installed in various environments within traffic control systems, installation flexibility of a mounting pole needs to be secured to allow the devices to be mounted on various structures, such as streetlight poles or external walls of buildings. Conventional brackets have suffered from limitations wherein installation is feasible only in specific environments, or wherein switching between vertical and horizontal orientations thereof is difficult. Accordingly, there is a demand for a fixing bracket that is compatible with various installation environments while effectively resolving heat dissipation issues, and a radar assembly including the same.

### SUMMARY

In view of the foregoing, the present disclosure has been conceived to provide a fixing bracket configured to stably secure a radar device and a junction box while simultaneously facilitating mounting of the radar device on various structures.

Also, the present disclosure has been conceived to implement a structure configured to effectively resolve heat dissipation issues occurring in a radar device.

The problems to be solved by the present disclosure are not limited to the above-described problems. There may be other problems to be solved by the present disclosure.

According to an exemplary embodiment, a fixing bracket for a radar device may include a first part configured to define a first seating space to receive the radar device therein, and include a support extending from a rear side toward a front side to support the radar device from a lower side or a lateral side when the radar device is seated in the first seating space; a second part configured to define a second seating space to receive a junction box therein, be disposed on a rear side of the first part, and integrally formed with the first part; and a coupling part configured to be integrally formed with the first part or the second part on a lower side of the second part and a rear side of the first part, extend in a longitudinal direction, and includes a rear end portion bent upward to extend therefrom.

According to an exemplary embodiment, a radar assembly may include a radar device configured to detect an object within a detection region through transmission and reception of electromagnetic waves; a junction box electrically or signally connected to the radar device; and a fixing bracket configured to fix the radar device and the junction box and to be fixedly coupled to an external structure, wherein the fixing bracket includes: a first part configured to define a first seating space to receive the radar device therein, and includes supports extending from a rear side toward a front side to support the radar device from a lower side or a lateral side when the radar device is seated in the first seating space; a second part configured to define a second seating space to receive the junction box therein, disposed on a rear side of the first part, and integrally formed with the first part; and a coupling part configured to be integrally formed with the first part or the second part on a lower side of the second part and a rear side of the first part, extends in a longitudinal direction, and includes a rear end portion bent upward to extend therefrom.

According to an embodiment of the present disclosure, a fixing bracket is configured to be mounted in each of vertical and horizontal orientations on various structures (e.g., streetlight poles, wall surfaces, supports, etc.), and is designed to be compatible with mounting poles having various diameters, thereby minimizing limitations on an installation environment thereof.

Furthermore, according to an embodiment of the present disclosure, there is provided a bracket structure configured to integrally secure a radar device and a junction box. Accordingly, both components may be simultaneously mounted via a single bracket without requiring a separate additional device.

Moreover, according to an embodiment of the present disclosure, heat generated from a GPU and a radar module within the radar device may be effectively dissipated.

### BRIEF DESCRIPTION OF THE DRAWINGS

In the detailed description that follows, embodiments are described as illustrations only since various changes and modifications will become apparent to a person with ordinary skill in the art from the following detailed description. The use of the same reference numbers in different figures indicates similar or identical items.
**FIG. 1A** is a front perspective view of a radar device according to an embodiment of the present disclosure.
**FIG. 1B** is a rear perspective view of the radar device according to an embodiment of the present disclosure.
**FIG. 1C** is a cross-sectional view of the radar device according to an embodiment of the present disclosure.
**FIG. 2** is a perspective view of a fixing bracket for a radar device according to an embodiment of the present disclosure.
**FIG. 3A** is a perspective view of an installation part of the fixing bracket for a radar device according to an embodiment of the present disclosure.
**FIG. 3B** is a view illustrating a coupling of the installation part to columns according to an embodiment of the present disclosure.
**FIG. 4A** is a perspective view of a switching part according to an embodiment of the present disclosure.
**FIG. 4B** is a perspective view of the fixing bracket in which a coupling direction is switched by the switching part according to an embodiment of the present disclosure.
**FIG. 5A** is a state diagram of a radar assembly installed on a vertical column according to an embodiment of the present disclosure.
**FIG. 5B** is a state diagram of the radar assembly installed on a horizontal column according to an embodiment of the present disclosure.
**FIG. 6** is a right rear perspective view of the radar assembly according to an embodiment of the present disclosure.
**FIG. 7** is a left rear perspective view of the radar assembly according to an embodiment of the present disclosure.
**FIG. 8** is a cross-sectional view of the radar assembly according to an embodiment of the present disclosure.
**FIG. 9** is a rear perspective view of the radar assembly in a state in which a cover part is removed according to an embodiment of the present disclosure.
**FIG. 10** is a front perspective view of the radar assembly in a state in which a front cover is mounted according to an embodiment of the present disclosure.
**FIG. 11A** is a front view of the front cover according to an embodiment of the present disclosure.
**FIG. 11B** is a rear view of the front cover according to an embodiment of the present disclosure.
**FIG. 11C** is a top view of the front cover according to an embodiment of the present disclosure.
**FIG. 11D** is a side view of the front cover according to an embodiment of the present disclosure.
**FIG. 12A** and **FIG. 12B** are views illustrating detection regions of a camera and an antenna included in the radar assembly according to an embodiment of the present disclosure.

### DETAILED DESCRIPTION

Hereinafter, embodiments of the present disclosure will be described in detail with reference to the accompanying drawings to be readily implemented by a person with ordinary skill in the art to which the present disclosure belongs. However, it is to be noted that the present disclosure is not limited to the example embodiments but can be embodied in various other ways. In the drawings, parts irrelevant to the description are omitted in order to clearly explain the present disclosure, and like reference numerals denote like parts through the whole document.

Through the whole document, when a member is said to be located "on" another member, this includes not only the case where the member is in contact with the other member, but also the case where another member exists between the two members.

Through the whole document, when a part "comprises or includes" a certain component, this means that it may further include other components rather than excluding other components unless specifically stated to the contrary.

As used through the whole document, the terms "about", "substantially", etc. are used to mean at or close to that value when manufacturing and material tolerances inherent to the stated meaning are presented, they are used to prevent unscrupulous infringers from taking unfair advantage of disclosures in which precise or absolute figures are mentioned to help understanding of the present disclosure. The term "step of" as used through the whole document does not mean "step for."

Throughout the whole document, the term "combination(s) of" included in Markush type description means mixture or combination of one or more components, steps, operations and/or elements selected from a group consisting of components, steps, operations and/or elements described in Markush type and thereby means that the disclosure includes one or more components, steps, operations and/or elements selected from the Markush group.

Through the whole document, references to "A and/or B" mean "A or B, or A and B."

Hereinafter, embodiments of the present disclosure will be described in detail with reference to the accompanying drawings. However, the present disclosure may not be limited to these implementations, examples, and drawings.

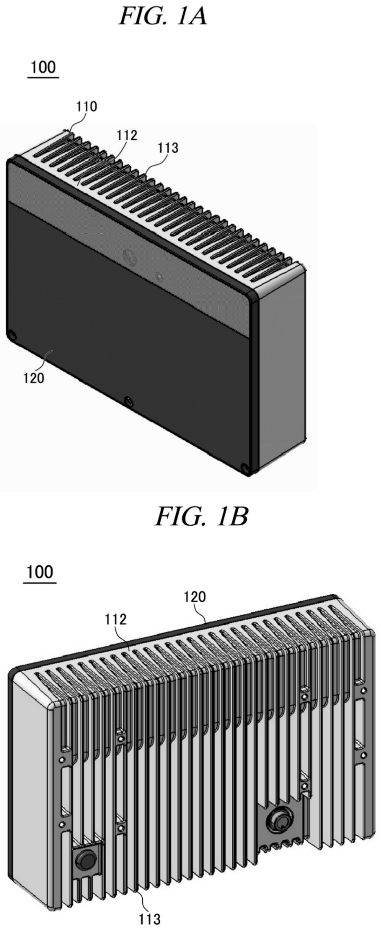

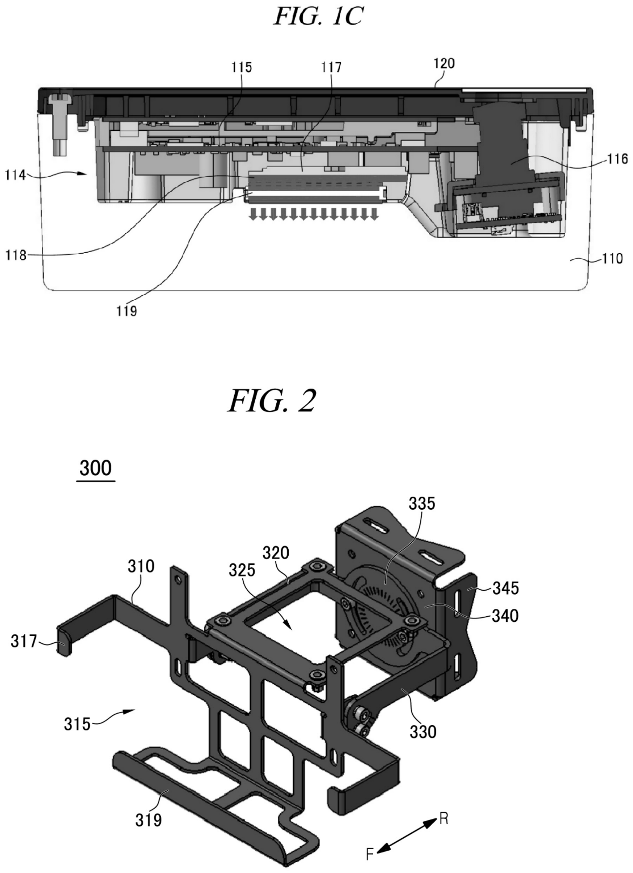

**FIG. 1A** is a front perspective view of a radar device 100 according to an embodiment of the present disclosure. **FIG. 1B** is a rear perspective view of the radar device 100 according to an embodiment of the present disclosure. **FIG. 1C** is a cross-sectional view of the radar device 100 according to an embodiment of the present disclosure.

Referring to **FIG. 1A** to **FIG. 1C****,** the radar device 100 according to an embodiment may be configured to detect an object within a detection region through transmission and reception of electromagnetic waves, and to perform analysis based on detected data.

The radar device 100 according to an embodiment may include a housing 110, and the housing 110 may have structural features for protecting internal components and improving heat dissipation performance.

In an embodiment, the housing 110 may include an open structure formed on a front side thereof and configured to face the detection region. In an embodiment, the open front surface of the housing 110 may be covered by a radome 120, and the radome 120 may be formed of a material that does not interfere with transmission and reception of electromagnetic waves. In an embodiment, the radome 120 may be integrally coupled to the housing 110.

In an embodiment, an accommodation space 114 may be formed inside the housing 110, and a circuit board 115 may be disposed within the accommodation space 114. In an embodiment, the circuit board 115 may include an antenna (not shown) configured to transmit and receive electromagnetic waves, through which an object within the detection region may be detected.

In an embodiment, the housing 110 may be designed to maximize heat dissipation performance and may be formed of a material having relatively high thermal conductivity (e.g., metal, etc.). In an embodiment, the housing 110 may be configured to dissipate heat through convection with ambient air.

In an embodiment, at least a portion of the housing 110 may have a reflectance with respect to light that is greater than or equal to a predetermined reflectance. For example, the housing 110 may be formed in a white color having a high reflectance with respect to light. Accordingly, the housing 110 may facilitate heat dissipation by reflecting most of incident light thereon rather than absorbing the incident light.

In an embodiment, a base 112 of the housing 110 may be configured to effectively transfer heat while stably securing the circuit board 115 and internal components.

In an embodiment, the housing 110 may include a plurality of heat dissipation fins 113 configured to extend rearward from the base 112 thereof. In an embodiment, the heat dissipation fins 113 may be arranged to extend in a vertical direction and be spaced apart from each other in a lateral direction, thereby increasing a contact area with air to maximize heat dissipation performance.

In an embodiment, a camera 116 for obtaining image data or video data may be included in the accommodation space 114 inside the housing 110.

In an embodiment, the circuit board 115 may include a graphics processing unit (GPU) 117 configured to analyze the image data or video data obtained through the camera 116. In an embodiment, the GPU 117 for high-speed data processing may be configured to analyze a large amount of video and radar data in real-time.

In an embodiment, since a significant amount of heat may be generated during an operation of the GPU 117, the GPU 117 may contact the housing 110 via a thermal interface material 118 to effectively dissipate heat. In an embodiment, the GPU 117 may be connected to the housing 110 to enable thermal conduction.

In an embodiment, the thermal interface material 118 may be configured to effectively transfer heat generated from the GPU 117 to the housing 110.

In an embodiment, a Peltier element 119 may be employed to further improve heat dissipation performance. In an embodiment, the Peltier element 119 may operate in a manner in which a first side thereof is cooled and an opposite side thereof generates heat upon application of a current thereto. By utilizing such a principle, the Peltier element 119 may be configured to facilitate dissipation of heat from the GPU 117.

The radar device 100 according to an embodiment of the present disclosure is configured to effectively manage heat dissipation performance while maximizing sensing and image processing performance. Accordingly, the radar device 100 is configured to operate stably even in a high-temperature environment, thereby enhancing reliability thereof.

In an embodiment, a port electrically or signally connected to a junction box or an external device may be formed on a rear surface of the housing 110.

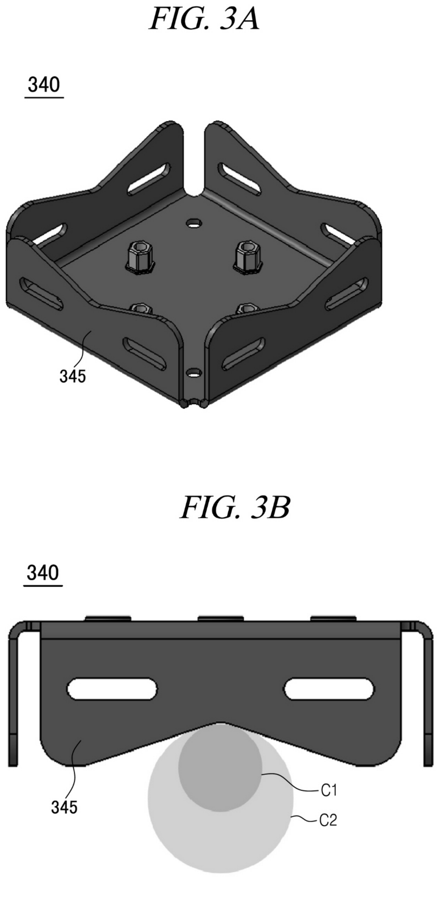

**FIG. 2** is a perspective view of a fixing bracket 300 for a radar device according to an embodiment of the present disclosure. **FIG. 3A** is a perspective view of an installation part 340 of the fixing bracket 300 according to an embodiment of the present disclosure. **FIG. 3B** is a view illustrating a coupling of the installation part 340 to columns C1 and C2 according to an embodiment of the present disclosure.

Referring to **FIG. 2****,** **FIG. 3A,** and **FIG. 3B****,** the fixing bracket 300 according to an embodiment may include a first part 310, a second part 320, and a coupling part 330.

The first part 310 according to an embodiment may define a first seating space 315 to receive the radar device 100 therein, and supports 317 and 319 may be formed to support the radar device 100 from a lower side or a lateral side when the radar device 100 is seated in the first seating space 315.

The second part 320 according to an embodiment may define a second seating space 325 to receive a junction box 200 therein. The second part 320 may be disposed on a rear side R of the first part 310 and may be integrally formed therewith.

The coupling part 330 according to an embodiment may extend from a lower side of the second part 320 and from the rear side R of the first part 310, and may be formed to be elongated in a longitudinal direction. Furthermore, in an embodiment, a rear end portion of the coupling part 330 may be bent upward to extend therefrom. Thus, the coupling part 330 may be stably coupled to an external structure.

In an embodiment, a front side (F, *e.g.*, a front side F of the first part 310) may be defined as a direction including the detection region of the radar device 100 seated on the first part 310. That is, the radar device 100 may be seated on the first part 310 in a manner in which a detection region or a detection direction thereof is oriented toward the front side F.

In an embodiment, each of the supports 317 and 319 of the first part 310 may include a front end portion extending from the rear side R toward the front side F, and the front end portion is bent inward at the front side F of the radar device 100 to restrict movement of the radar device 100. For example, the support 317 configured to support the radar device 100 from a lateral side (left and/or right side) may extend toward the front side F of the radar device 100, and a front end portion thereof may be bent inward (toward the right and/or left side). For example, the support 319 configured to support the radar device 100 from a lower side may extend toward the front side F of the radar device 100, and a front end portion thereof may be bent upward.

In an embodiment, the supports 317 and 319 of the first part 310 may be configured to support the radar device 100 from both lateral sides and a lower side thereof, thereby defining the first seating space 315 having an open top. In an embodiment, the first seating space 315 may be formed to receive the radar device 100 inserted therein from above.

In an embodiment, the second seating space 325 may be formed to receive the junction box 200 therein from above. In an embodiment, the second seating space 325 may extend in a planar direction thereof, and the junction box 200 may be fixed to the second part 320 by a separate fastening means, such as a screw, while being seated in the second seating space 325.

In an embodiment, the coupling part 330 may be integrally coupled to the first part 310 or the second part 320, and may extend along the longitudinal direction from the lower side of the second part 320 toward a rear side of the first part 310.

In an embodiment, the rear end portion of the coupling part 330 may be bent upward to extend in a vertical direction. In an embodiment, a mounting cradle 335 may be formed at the rear end portion of the coupling part 330 to be stably coupled to the external structure.

In an embodiment, the mounting cradle 335 may be formed on the coupling part 330, and the mounting cradle 335 may extend in a planar direction intersecting the longitudinal direction on a rear side of the first part 310 and the second part 320.

The fixing bracket 300 according to an embodiment may further include the installation part 340 coupled directly or indirectly to the mounting cradle 335. In an embodiment, the installation part 340 may be configured to be stably coupled to an external structure.

In an embodiment, the installation part 340 may be fixedly coupled to the mounting cradle 335 at a plurality of coupling positions.

In an embodiment, the installation part 340 may have a shape with a plurality of corners respectively corresponding to an upper side, a lower side, a left side, and a right side. Accordingly, the installation part 340 may be coupled to columns C1 and C2 through the plurality of corners corresponding to various directions (e.g., four directions).

In an embodiment, at least a portion of the plurality of corners of the installation part 340 may be bent and extend toward the rear side R, and a rear end portion 345 extending from the bent portion may be recessed obliquely from both sides toward a center thereof. In an embodiment, the plurality of corners of the installation part 340 may be bent and extend toward the rear side R, and the rear end portion 345 may have a "V"-shaped configuration in which a groove is formed at the center by being recessed inward from both sides of the corner.

In an embodiment, as illustrated in **FIG. 3B****,** the installation part 340 may be compatible for installation on the columns C1 and C2 of various sizes (*e.g*., diameters) due to the recessed shape of the installation part 340.

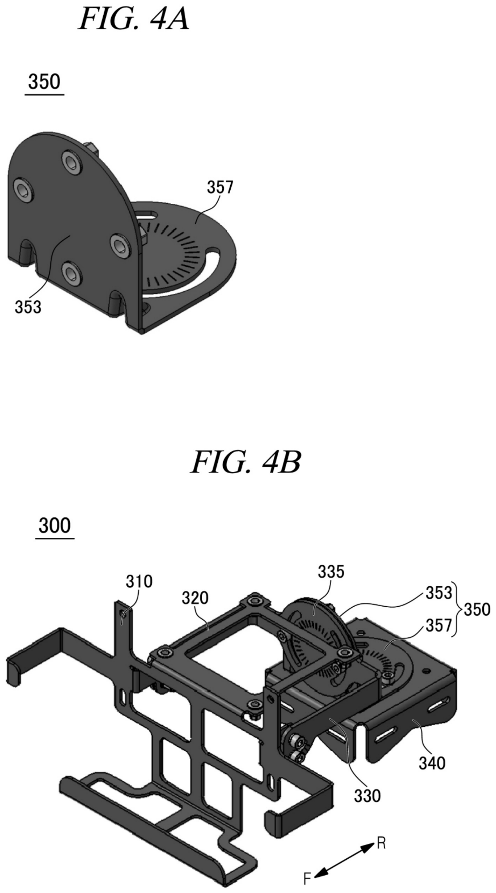

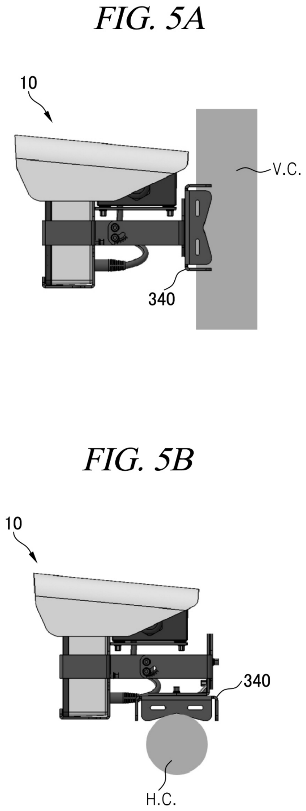

**FIG. 4A** is a perspective view of a switching part 350 according to an embodiment of the present disclosure. **FIG. 4B** is a perspective view of the fixing bracket 300 in which a coupling direction is switched by the switching part 350 according to an embodiment of the present disclosure. **FIG. 5A** is a state diagram of a radar assembly 10 installed on a vertical column V.C. according to an embodiment of the present disclosure. **FIG. 5B** is a state diagram of the radar assembly 10 installed on a horizontal column H.C. according to an embodiment of the present disclosure.

Referring to **FIG. 4A, FIG. 4B****,** **FIG. 5A** and **FIG. 5B****,** the fixing bracket 300 according to an embodiment may further include the switching part 350 bent and extending in a first planar direction and a second planar direction intersecting the first planar direction.

In an embodiment, the switching part 350 may be composed of a first surface 353 extending in the first planar direction and a second surface 357 extending in the second planar direction intersecting the first planar direction.

In an embodiment, the switching part 350 may be orthogonally bent by extending in each of the first planar direction and the second planar direction. In an embodiment, the first surface 353 may be fixedly coupled to the mounting cradle 335, and the second surface 357 may be coupled to an installation part 340.

In an embodiment, the switching part 350 may be coupled to the mounting cradle 335 to change a coupling direction of the mounting cradle 335 from the first planar direction to the second planar direction. In an embodiment, the second surface 357 of the switching part 350 and the installation part 340 coupled to the second surface 357 may extend in a direction intersecting the first surface 353 of the switching part 350 and the mounting cradle 335 coupled to the first surface 353.

As illustrated in **FIG. 5A****,** the fixing bracket 300 according to an embodiment may secure the radar assembly 10 to the vertical column V.C. In this case, the fixing bracket 300 may not include the switching part 350.

As illustrated in **FIG. 5B****,** the fixing bracket 300 according to an embodiment may secure the radar assembly 10 to the horizontal column H.C. In this case, the fixing bracket 300 may include the switching part 350.

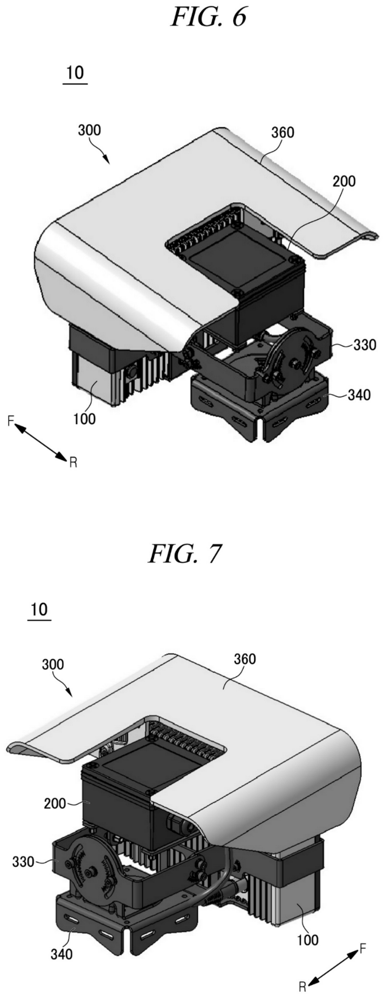

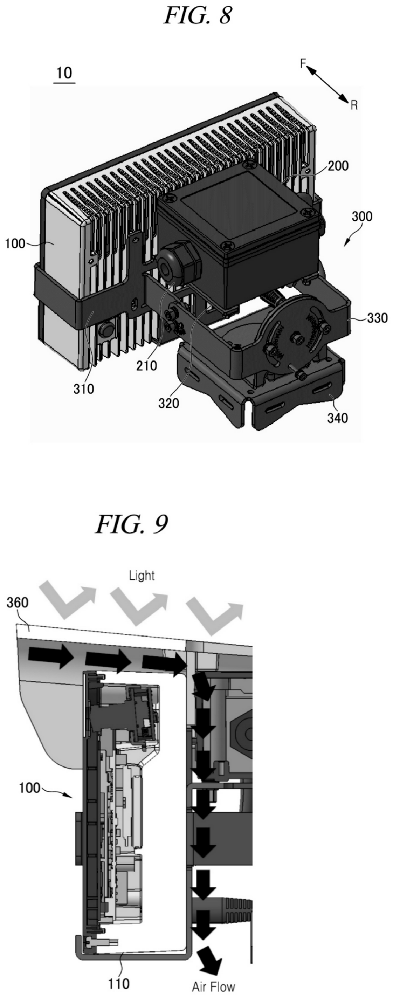

**FIG. 6** is a right rear perspective view of the radar assembly 10 according to an embodiment of the present disclosure. **FIG. 7** is a left rear perspective view of the radar assembly 10 according to an embodiment of the present disclosure. **FIG. 8** is a cross-sectional view of the radar assembly 10 according to an embodiment of the present disclosure. **FIG. 9** is a rear perspective view of the radar assembly in a state in which a cover part 360 is removed according to an embodiment of the present disclosure.

Referring to **FIG. 6** to **FIG. 9****,** the radar assembly 10 according to an embodiment may include the radar device 100, the junction box 200, and the fixing bracket 300 configured to secure the radar device 100 and the junction box 200 and to be fixedly coupled to an external structure.

In an embodiment, the junction box 200 connected to the radar device 100 may perform various functions to facilitate stable and efficient operation of a radar system.

In an embodiment, the junction box 200 may define a space where cables (*e.g.*, DC power or Ethernet) introduced from an external environment are connected, providing connection points for wires and cables associated with the radar device 100, and may be configured to protect such connections from the external environment. Accordingly, the junction box 200 may maintain system stability by suppressing electrical damage, corrosion, physical impact, and the like.

In an embodiment, the junction box 200 may be configured to collect signals generated from the radar device 100 and to process the signals or transmit them to another system. For example, the junction box 200 may aggregate radar signals or data for transmission to a sensor fusion processor, and may support connectivity functions thereof.

In an embodiment, the junction box 200 may suppress malfunctions caused by external electromagnetic interference (EMI) or in-vehicle noise through a noise filtering function, and may improve the quality of radar signals.

In an embodiment, the junction box 200 may monitor current, insulation resistance, contact resistance, and the like in a high-voltage system to ensure safe operation, thereby minimizing electrical hazards associated with the radar device 100.

In an embodiment, the junction box 200 may enhance system scalability through a modular design and may improve work efficiency by providing accessibility during maintenance operations.

In an embodiment, the junction box 200 is secured to the fixing bracket 300 at a position adjacent to the radar device 100, and a connector 210 electrically or signally connected to the radar device 100 may be formed on a side surface thereof.

In an embodiment, cables connected to the radar device 100 are disposed inside the junction box 200, and connectors 210 for DC power and/or Ethernet connection may be formed on both side surfaces of the junction box 200.

The radar assembly 10 according to an embodiment may further include the cover part 360 covering the first part 310 from above.

In an embodiment, the cover part 360 may extend from a position disposed forward F of the first part 310 toward the rear side R to cover the first part 310 from above. In an embodiment, by covering the first part 310 from above, the cover part 360 may block light, such as natural light (*e.g*., sunlight), from being directly irradiated onto the first part 310.

In an embodiment, at least a portion of the cover part 360 may have a reflectance with respect to light that is greater than or equal to a predetermined reflectance. For example, the cover part 350 may be formed in a white color to reflect most of light rather than absorbing it.

In an embodiment, as illustrated in **FIG. 9****,** the cover part 360 may be disposed to be spaced upward from the radar device 100 when the radar device 100 is seated in the first seating space 315. Accordingly, air may flow through a separation space between the radar device 100 and the cover part 350 and through the heat dissipation fins 113 formed on the housing 110 of the radar device 100, thereby improving the heat dissipation performance of the radar device 100.

In an embodiment, the cover part 360 may extend in a manner that avoids interference with the second seating space 325 or the junction box 200 seated in the second seating space 325.

In an embodiment, the cover part 360 may extend in the longitudinal direction, and a central portion thereof may extend a relatively short distance so as not to overlap an upper portion of the second seating space 325, while both side portions thereof may extend a relatively long distance.

In an embodiment, the cover part 360 may extend with both end portions thereof bent downward, thereby effectively blocking light irradiated onto the radar device 100 seated in the first seating space 315.

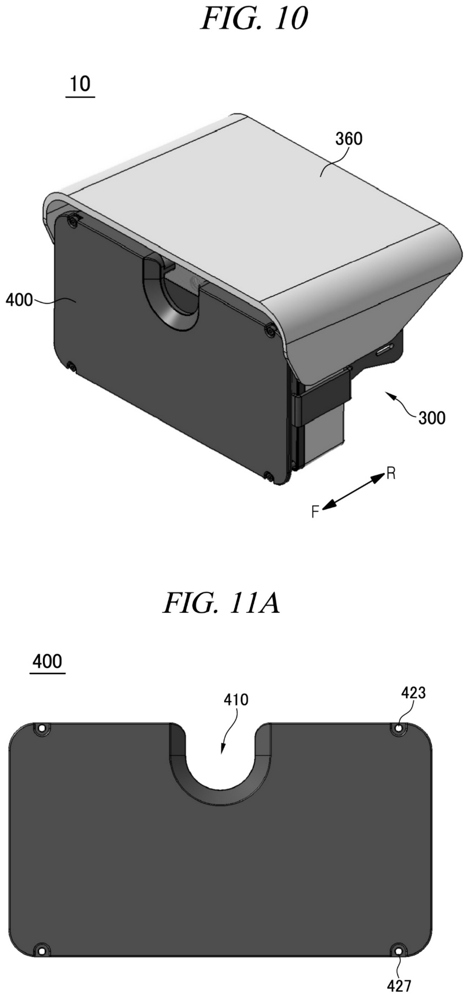

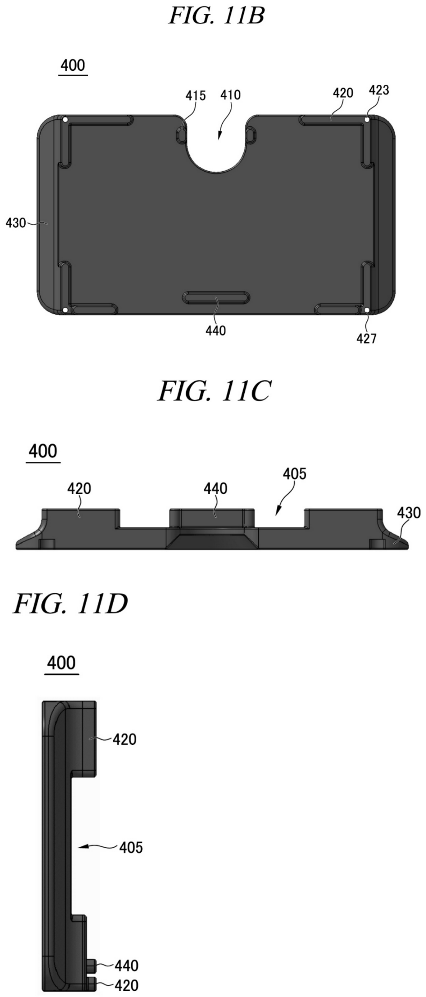

**FIG. 10** is a front perspective view of the radar assembly 10 in a state in which a front cover 400 is mounted according to an embodiment of the present disclosure. **FIG. 11A** is a front view of the front cover 400 according to an embodiment of the present disclosure. **FIG. 11B** is a rear view of the front cover 400 according to an embodiment of the present disclosure. **FIG. 11C** is a top view of the front cover 400 according to an embodiment of the present disclosure. **FIG. 11D** is a side view of the front cover 400 according to an embodiment of the present disclosure.

Referring to **FIG. 10** and **FIG. 11A** **to** **FIG. 11D****,** the radar assembly 10 according to an embodiment may further include the front cover 400 configured to cover at least a portion of a front surface of the radar device 100.

The front cover 400 according to an embodiment may be disposed on the front side F of the radar device 100 and may extend in a planar direction parallel to the front surface of the radar device 100 to cover at least a portion of the front surface thereof. In an embodiment, the front cover 400 may cover the radome 120 of the radar device 100.

The front cover 400 according to an embodiment may be configured to comply with a predetermined impact test (*e.g.*, an IK10 rating) for the radome 120. According to the above embodiment, the performance of the radar assembly 10 against physical impact may be improved. For example, the radar assembly 10 including the front cover 400 may ensure impact resistance (*e.g*., an IK10 rating). Herein, the IK10 rating is defined based on a physical impact test specifying that a product remains structurally intact when subjected to an impact corresponding to a 5 kg mass dropped from a height of 40 cm thereabove.

In an embodiment, a camera groove 410 may be formed in the front cover 400 to avoid interference with a detection region of the camera 116. In an embodiment, the camera groove 410 may be disposed in front of the camera 116 and formed to avoid interference with the detection region of the camera 116.

In an embodiment, the front cover 400 may be integrally coupled to the radar device 100. In an embodiment, the front cover 400 may be integrally coupled to the radome 120 by fastening members, such as screws or bolts.

In an embodiment, the front cover 400 may be disposed outside the first seating space 315 while being integrally coupled to the radar device 100.

In an embodiment, the front cover 400 may have grooves recessed inward at both end portions 430 thereof. In an embodiment, the front cover 400 may be formed to have a relatively reduced thickness at the both end portions 430. In an embodiment, the front cover 400 integrally coupled to the radar device 100 may slide along the recessed grooves of both end portions 430 with the support 317 supporting the radar device 100 from a lateral side (left and/or right side).

In an embodiment, the radar device 100 may be seated in the first seating space 315 in a state in which the front cover 400 is integrally coupled to the radome 120 at an upper position 423 via screw coupling. In an embodiment, in a state in which the radar device 100 is seated in the first seating space 315, the front cover 400 may be integrally coupled to the radome 120 at a lower position 427 via screw coupling.

In an embodiment, the front cover 400 may define a separation space 405 between at least a portion thereof and the front surface of the radar device 100. Herein, the separation space 405 may protect the radar device 100 from physical impact by forming an air gap between the front cover 400 and the radome 120. For example, a height of the separation space 405 may account for a majority of a height of the front cover 400.

In an embodiment, the front cover 400 may be supported by a plurality of supports 415, 420 and 440 to define the separation space 405 relative to the front surface of the radar device 100.

In an embodiment, a groove support 415 may be formed around the camera groove 410 of the front cover 400. For example, the groove support 415 may be positioned on lateral sides (*e.g*., each of left and right sides) of the camera groove 410 and disposed closely to the camera groove 410.

In an embodiment, a corner support 420 may be formed at each corner of the front cover 400 and may be supported by the front surface of the radar device 100 to define the separation space 405. For example, the corner support 420 may extend by a predetermined length in each of vertical and horizontal directions.

In an embodiment, a lower support 440 may be positioned below the camera groove 410 and may extend in the horizontal direction. For example, the lower support 440 may extend to a length corresponding to a horizontal extension length of the camera groove 410.

In an embodiment, the front cover 400 is supported by the plurality of supports 415, 420 and 440, thereby minimizing interference with the fixing bracket 300 and suppressing accumulation of foreign substances, such as water, dust, or sand.

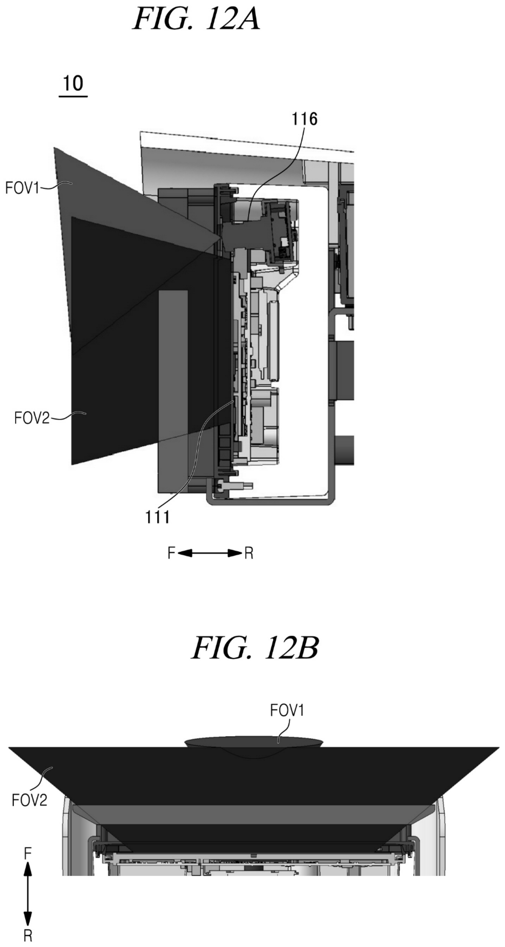

**FIG. 12A** and **FIG. 12B** are views illustrating detection regions FOV1 and FOV2 of the camera 116 and an antenna 111 included in the radar assembly 10 according to an embodiment of the present disclosure.

Referring to **FIG. 12A** and **FIG. 12B****,** the radar device 100 may include the camera 116 configured to obtain image data or video data, and the antenna 111 configured to transmit and receive electromagnetic waves.

The front cover 400 according to an embodiment may extend in a planar direction parallel to the front surface of the radar device 100 while avoiding interference with the detection region FOV1 of the camera 116. In an embodiment, the camera groove 410 may be formed in the front cover 400 to avoid interference with the detection region of the camera 116.

In the front cover 400 according to an embodiment, the camera groove 410 may be designed to avoid interference with the detection region FOV1 of the camera 116. In an embodiment, at least a portion of the front cover 400 may be inclined rearward at a position corresponding to the camera 116 (*e.g.*, at a peripheral portion of the camera groove 410). In an embodiment, the front cover 400 may be inclined rearward in a direction toward the camera 116 at the peripheral portion of the camera groove 410.

At least a portion of the front cover 400 according to an embodiment may overlap the detection region FOV2 of the antenna 111.

In an embodiment, the front cover 400 may be formed of a non-metallic material (e.g., polycarbonate (PC)) so as not to interfere with transmission and reception of electromagnetic waves through the antenna 111.

The above description of the present disclosure is provided for the purpose of illustration, and it would be understood by a person with ordinary skill in the art to which the present disclosure belongs that various changes and modifications may be made without changing technical conception and essential features of the present disclosure. Thus, it is clear that the above-described examples are illustrative in all aspects and do not limit the present disclosure. For example, each component described to be of a single type can be implemented in a distributed manner, likewise, components described to be distributed can be implemented in a combined manner.

The scope of the present disclosure is defined by the following claims rather than by the detailed description of the embodiment, and it should be understood that all modifications and embodiments conceived from the meaning and scope of the claims and their equivalents are included in the scope of the present disclosure.

## Claims

1. A fixing bracket for a radar device, comprising:
a first part configured to define a first seating space to receive the radar device therein, and including a support extending from a rear side toward a front side to support the radar device from a lower side or a lateral side when the radar device is seated in the first seating space;
a second part configured to define a second seating space to receive a junction box therein, being disposed on a rear side of the first part, and being integrally formed with the first part; and
a coupling part configured to be integrally formed with the first part or the second part on a lower side of the second part and a rear side of the first part, extending in a longitudinal direction, and including a rear end portion bent upward to extend therefrom.

2. The fixing bracket of Claim 1,
wherein a front side of the first part is defined as a direction including a detection region of the radar device seated in the first part.

3. The fixing bracket of Claim 1,
wherein each of the supports includes a front end portion extending from the rear side toward the front side and bent inward at the front side of the radar device to restrict movement of the radar device.

4. The fixing bracket of Claim 1,
wherein the first seating space is formed to receive the radar device inserted therein from above, and
the second seating space is formed to receive the junction box therein from above.

5. The fixing bracket of Claim 1,
wherein a mounting cradle is formed on the coupling part and extends in a planar direction intersecting the longitudinal direction on the rear side of the first part and the second part.

6. The fixing bracket of Claim 5, further comprising:
an installation part which has a shape with a plurality of corners respectively corresponding to an upper side, a lower side, a left side, and a right side, and in which at least a portion of the plurality of corners is bent and extends toward a rear side and a rear end portion extending from the bent portion is recessed obliquely from both sides toward a center thereof,
wherein the installation part is coupled directly or indirectly to the mounting cradle.

7. The fixing bracket of Claim 5, further comprising:
a switching part that is bent by extending in each of a first planar direction and a second planar direction intersecting the first planar direction,
wherein the switching part is coupled to the mounting cradle to change a coupling direction of the mounting cradle from the first planar direction to the second planar direction.

8. The fixing bracket of Claim 1, further comprising:
a cover part that extends from a position disposed forward of the first part toward a rear side thereof to cover the first part from above,
wherein the cover part is disposed to be spaced upward from the radar device when the radar device is seated in the first seating space.

9. The fixing bracket of Claim 8,
wherein at least a portion of the cover part has a reflectance with respect to light that is greater than or equal to a predetermined reflectance, and
the cover part extends in a manner that avoids interference with the second seating space or the junction box seated in the second seating space.

10. A radar assembly, comprising:
a radar device configured to detect an object within a detection region through transmission and reception of electromagnetic waves;
a junction box electrically or signally connected to the radar device; and
a fixing bracket configured to fix the radar device and the junction box and to be fixedly coupled to an external structure,
wherein the fixing bracket includes:
a first part configured to define a first seating space to receive the radar device therein, and includes supports extending from a rear side toward a front side to support the radar device from a lower side or a lateral side when the radar device is seated in the first seating space;
a second part configured to define a second seating space to receive the junction box therein, disposed on a rear side of the first part, and integrally formed with the first part; and
a coupling part configured to be integrally formed with the first part or the second part on a lower side of the second part and a rear side of the first part, extending in a longitudinal direction, and including a rear end portion bent upward to extend therefrom.

11. The radar assembly of Claim 10,
wherein the radar device includes:
a housing which has an open front surface corresponding to the detection region and in which an accommodation space is formed;
a radome that covers the front surface of the housing and is integrally coupled to the housing; and
a circuit board that is disposed within the accommodation space of the housing and includes an antenna, and
the housing is connected to the circuit board for direct or indirect heat transfer and is configured to dissipate heat through convection with ambient air.

12. The radar assembly of Claim 11,
wherein the radar device includes a camera configured to obtain image data or video data,
the circuit board includes a graphics processing unit (GPU) configured to process the obtained image data or video data, and
the GPU is connected to the housing to enable thermal conduction via a thermal interface material (TIM).

13. The radar assembly of Claim 12,
wherein the circuit board further includes a Peltier element configured to actively dissipate heat generated from the GPU.

14. The radar assembly of Claim 11,
wherein at least a portion of the housing has a reflectance with respect to light that is greater than or equal to a predetermined reflectance, and the housing includes a base and a plurality of heat dissipation fins extending rearward from the base and spaced apart from each other in a lateral direction.

15. The radar assembly of Claim 11, further comprising:
a front cover that is configured to cover at least a portion of a front surface of the radar device and integrally coupled to the radar device,
wherein the front cover defines a separation space between at least a portion thereof and the front surface of the radar device.
